# EUROPÄISCHE PATENTSCHRIFT

(11) **EP 2 187 716 B1**
(45) Veröffentlichungstag und Bekanntmachung des Hinweises auf die Patenterteilung: **21.12.2011**
(21) Anmeldenummer: 09012894.3
(22) Anmeldetag: 13.10.2009
(51) Int. Cl.: H05K 1/14, H05K 3/36

(54) **Zentralbaugruppe für ein flexibles erweiterbares Automatisierungsgerät**
Central component for a flexibly expandable automation device
Bloc central pour un appareil d'automatisation agrandissable flexible

(30) Priorität: 18.11.2008 DE 102008058060
(43) Veröffentlichungstag der Anmeldung: 19.05.2010
(73) Patentinhaber: ABB AG, 68309 Mannheim (DE)
(72) Erfinder: Gaub, Gernot, Dipl.-Ing., 68766 Hockenheim (DE); Gloeckner, Gerd, 69121 Heidelberg (DE); Wilmers, Andreas, Dipl.-Phys., 69123 Heidelberg (DE); Yang, Deqiang, 69163 Mannheim (DE); Su, YongHui, Xiamen (CN); Wang, YiLing, Xiamen Fujian (CN); Chen, YiQing, Xiamen (CN)

(56) Entgegenhaltungen:
- DE-A1- 3 838 353
- US-A- 5 519 573
- US-A- 5 552 965
- US-A1- 2007 293 954

## Beschreibung

Die Erfindung betrifft eine Zentralbaugruppe für ein flexibles erweiterbares Automatisierungsgerät gemäß dem Oberbegriff des Anspruches 1.

Marktübliche oder in Patentdokumenten beschriebene erweiterbare Automatisierungsgeräte, auch als speicherprogrammierbare Steuerungen bekannt, sind an unterschiedlichste Automatisierungsaufgaben anpassbar und werden insbesondere im Bereich der industriellen Automatisierungstechnik und im Bereich der Schalt- und Steuerungstechnik eingesetzt.

Diese Automatisierungssysteme sind üblicherweise modular aus einer Zentralbaugruppe, Kommunikationskoppiern und Erweiterungsmodulen aufgebaut. Die Zentralbaugruppe gemäß dem bekannten Stand der Technik umfasst verschiedene Baugruppen, wie eine Zentraleinheit, auch als CPU bezeichnet, eine Spannungsversorgung, eine Schnittstelle für den Anschluss von externen Ein- und Ausgabemodulen und interne Ein- und Ausgabemodule. Ein- Und Ausgabemodule_{.}

Die DE 3838353 A1 (vergl. Oberbegriff des Anspruchs 1) zeigt einen Verstärker für ein Ventil auf einer Trägerplatine. Die Trägerplatine ist mit einer Endstufe und einem Netzteil bestückt. Außerdem trägt sie eine Tochter-Platine, auf der ein programmierbarer Baustein und ein Festwertspeicher angeordnet sind. Die Trägerplatine weist ferner Eingänge sowie Anschlüsse für die Spannungsversorgung des Netzteils und zum Anschluss des Ventils an die Endstufe und Schnittstelle zum Datenaustausch mit einem Rechner auf.

In der US 2007/0293954 A1 ist ein in einem Gehäuse angeordnetem Controller mit mehreren Baugruppenträgern bzw. Leiterplatten gezeigt.

Auch die US 5552965 A zeigt ein programmierbares Steuergerät, Steuergerät mit in einem Gehäuse untergebrachten Leiterplatten, welche austauschbar sind.

Bedingt durch die unterschiedlichen funktionellen und mechanischen Ausführungen der einzelnen Baugruppen der Zentralbaugruppe ist die Herstellung der Zentralbaugruppe, insbesondere bedingt durch mehrere aufeinander abzustimmende Lötprozesse zur Vermeidung der Zerstörung einzelner Bauelemente der Baugruppen, aufwendig und kostenintensiv.

Der Erfindung liegt demgemäß die Aufgabe zugrunde, eine Zentralbaugruppe für ein flexibles erweiterbares Automatisierungsgerät, anzugeben, bei dem die vorgenannten Nachteile überwunden werden, und die Zentralbaugruppe, insbesondere in einfacher und kostengünstiger Weise, herstellbar ist.

Diese Aufgabe wird erfindungsgemäß durch eine Zentralbaugruppe für ein flexibles erweiterbares Automatisierungsgerät mit den in Anspruch 1 angegebenen Merkmalen gelöst. Vorteilhafte Ausgestaltungen und Verbesserungen der erfindungsgemäßen Zentralbaugruppe sind in weiteren Ansprüchen und in der Beschreibung angegeben.

Die erfindungsgemäße Zentralbaugruppe für ein flexibles erweiterbares Automatisierungsgerät umfasst ein Gehäuse, weiches die verschiedenen Baugruppen, wie beispielsweise eine Zentraleinheit, eine Spannungsversorgung, eine Schnittstelle für den Anschluss von externen Ein- und Ausgabemodulen und interne Ein- und Ausgabemodule aufnimmt.

Erfindungsgemäß ist die Zentralbaugruppe aus drei Elektronikbaugruppen aufgebaut, die jeweils auf einem separaten Träger, der als Leiterplatte oder Platine ausgeführt ist, angeordnet sind. Ein erster Träger ist für die Aufnahme der Elektronikbaugruppe der Zentraleinheit, ein zweite Träger zur Aufnahme der Elektronikbaugruppe der internen Ein- und Ausgabemodule sowie von Anzeigemitteln für die internen Ein- und Ausgabemodule und ein dritter Träger ist zur Aufnahme der Elektronikbaugruppe der Spannungsversorgung sowie der Schnittstelle für den Anschluss externer Module, wie beispielsweise externer Ein- und Ausgabemodule, vorgesehen. Der dritte Träger mit der Elektronikbaugruppe zur Spannungsversorgung der Zentralbaugruppe ist zwischen dem ersten und dem zweiten Träger gegenüber der Frontseite des Gehäuses angeordnet.

Der erste und der zweite Träger der Zentralbaugruppe sind mit dem dritten Träger mechanisch und elektrisch verbunden. Vorzugsweise sind die Träger zur mechanischen und elektrischen Verbindung untereinander verlötet, beispielsweise wird die Verbindung der Träger mittels verlöteter Stifte realisiert. Dadurch entfällt die Steckverbindung zwischen den einzelnen Trägern und es wird eine bessere mechanische Stabilität erreicht.

Die Träger sind in im wesentlichen rechtwinklig zueinander angeordnet, wobei der dritte die Spannungsversorgung der Zentralbaugruppe sowie die Schnittstelle für den Anschluss der externen Ein- und Ausgabemodule aufnehmende Träger zwischen dem zweiten die internen Ein- und Ausgabemodule aufnehmenden Träger und dem ersten die Zentraleinheit aufnehmenden Träger angeordnet ist.

In einer bevorzugten Ausführungsform der Zentralbaugruppe weisen nur der zweite und der erste Träger Anschlusselemente, vorzugsweise steckbare oder verlötbare Klemmen, Steckerleisten oder Klemmenblöcke auf, beispielsweise zum Anschluss externer Signale weiterer externer Erweiterungsmodule, die beispielsweise als Ein- und Ausgabemodule ausgeführt sind. Somit wird eine Reduktion der Steckverbindungen zwischen den drei Elektronikbaugruppen bzw. Trägern erreicht, da die Träger miteinander verlötet sind und die elektrische Verbindung zwischen den Trägern ohne zusätzliche Steckverbindungen gewährleistet ist.

Erfindungsgemäß ist der erste Träger, bedingt durch die darauf befindlichen Bauelemente der Zentraleinheit, gegenüber dem zweiten und dritten Träger als komplexe mehrlagige Leiterplatte ausgeführt und die Anzahl der Lagen des ersten Trägers ist gegenüber der Anzahl der Lagen des zweiten und dritten Trägers erhöht.

In einer bevorzugten Ausführungsform der Zentralbaugruppe sind auf dem ersten Träger auch die Ethernet-Schnittstelle und/oder eine, vorzugsweise abdeckbare, Vorrichtung als Steckplatz für die Aufnahme von nachrüstbarem Zubehör vorgesehen. Das nachrüstbare Zubehör können austauschbare Leiterplatten für weitere Interfaceschaltungen, Speicherkarten oder zur Aufnahme einer Echtzeituhr sein.

Die auf dem ersten und zweiten Träger befindlichen Anzeigemittel für die Anzeige der Ein- und Ausgabemodule sind als Lichtleiter ausgeführt und dafür vorgesehen, das Licht zu bündeln und kontaktlos auf die Frontseite der Zentralbaugruppe zu übertragen.

Durch den vereinfachten mechanischen Aufbau der Zentralbaugruppe bezüglich der Integration der funktional unterschiedlichen Baugruppen entsprechend ihren Funktionen auf drei Trägern gestaltet sich die Herstellung der Zentralbaugruppe kostengünstig, da die auf den verschiedenen Trägern angeordneten Elektronikbaugruppen mit dem jeweils optimal geeigneten Lötprozess gefertigt werden können.

Die mehrlagige Leiterplatte (erster Träger), welche mit den Bauteilen für die Zentraleinheit, wie beispielsweise Mikrocontroller, Speicher und Logikbausteinen, bestückt ist, wird vorzugsweise beidseitig im SMD Prozess bestückt und gelötet, oder in Kombination mit einem zusätzlichen selektiven Lötprozess für die Verbindungsstifte zur mechanischen und elektrischen Verbindung der Leiterplatten untereinander.

Die Leiterplatte, welche die Elektronikbaugruppe der internen Ein- und Ausgabemodule aufnimmt (zweiter Träger), kann in Abhängigkeit von den verwendeten Bauteilen beidseitig im SMD Prozess, oder einseitig im SMD Prozess und auf der anderen Seite im Wellenlötprozess oder zweiseitig im SMD Prozess mit zusätzlichem selektiven Löten der bedrahteten Bauteile bestückt und gelötet werden.

Die Leiterplatte für die Spannungsversorgung und die Schnittstelle für den Anschluss externer Module (dritter Träger) kann je nach verwendeten Bauteilen ein- oder zweiseitig im SMD Prozess bestückt und gelötet werden. Bedrahtete Bauteile sowie die Verbindungen zwischen alle drei LP können dagegen mittels eines Wellenlötprozesses verarbeitet werden.

Anhand der in den folgenden Figuren dargestellten Ausführungsformen sollen die Erfindung sowie vorteilhafte Ausgestaltungen, Verbesserungen und weitere Vorteile der Erfindung näher erläutert und beschrieben werden.

Es zeigen:
- **Fig. 1**: eine beispielhafte Ausführung einer Zentralbaugruppe für ein flexibles er- weiterbares Automatisierungsgerät,

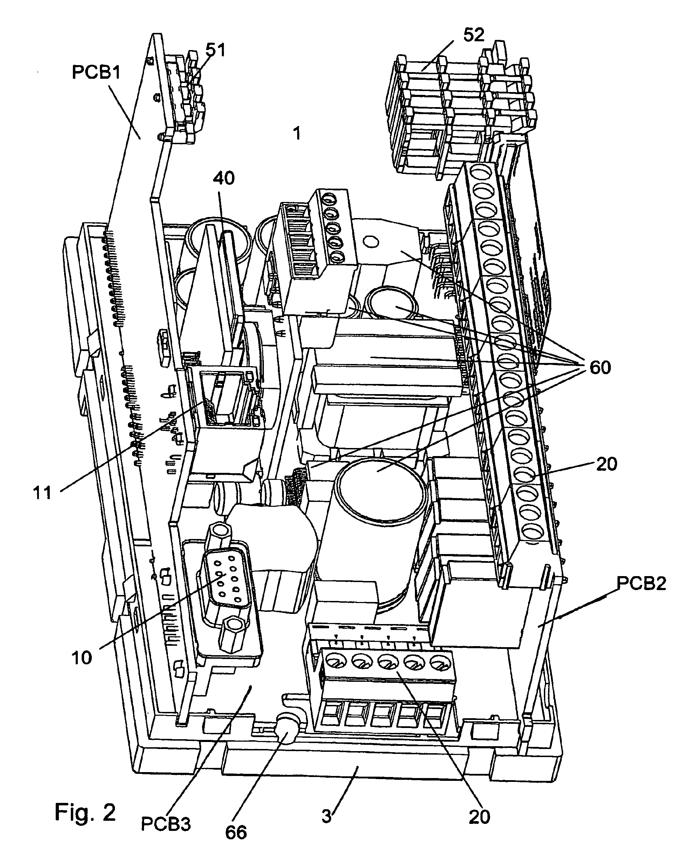

- **Fig. 2**: eine beispielhafte Ausführung der Leiterplatten der Zentralbaugruppe mit den darauf angeordneten Elektronikbaugruppen,

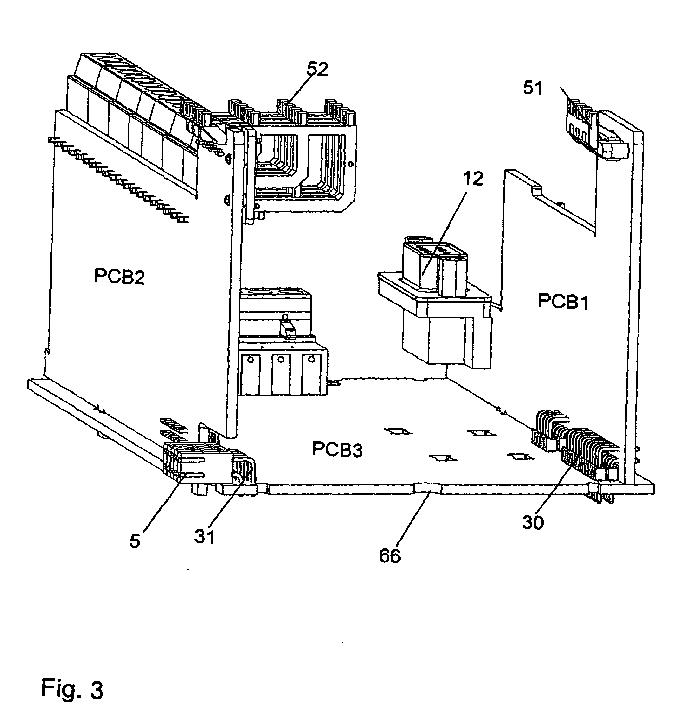

- **Fig. 3**: eine beispielhafte Verbindungslösung der Leiterplatten untereinander,
- **Fig. 4**: eine Ausführungsform der auf der ersten Leiterplatte befindlichen Vorricht- und als Steckplatz für die Aufnahme von nachrüstbarem Zubehör,

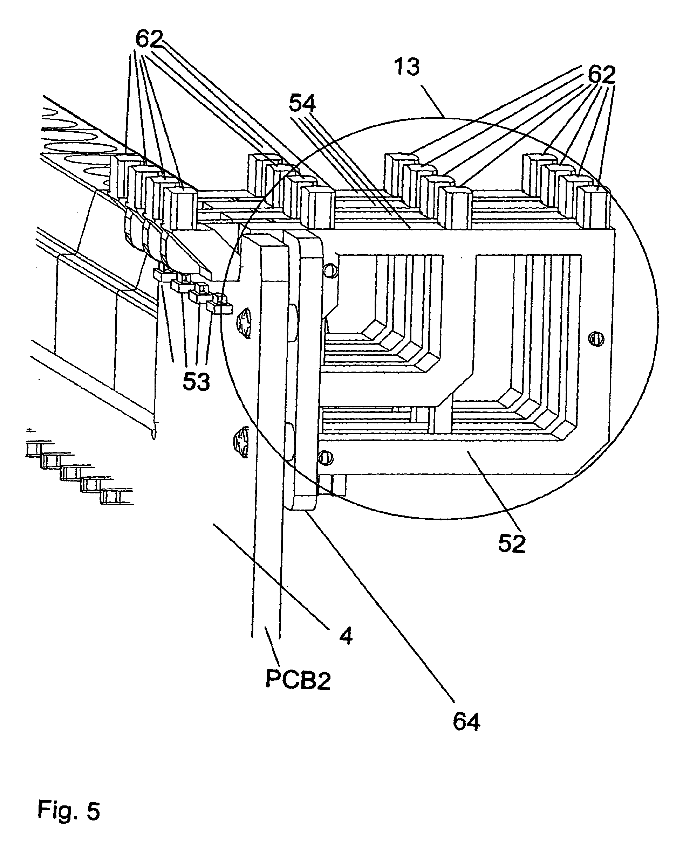

- **Fig. 5**: eine beispielhafte Ausführung eines Anzeigemittels der Zentralbaugruppe, welches auf der zweiten Leiterplatte angeordnet ist,

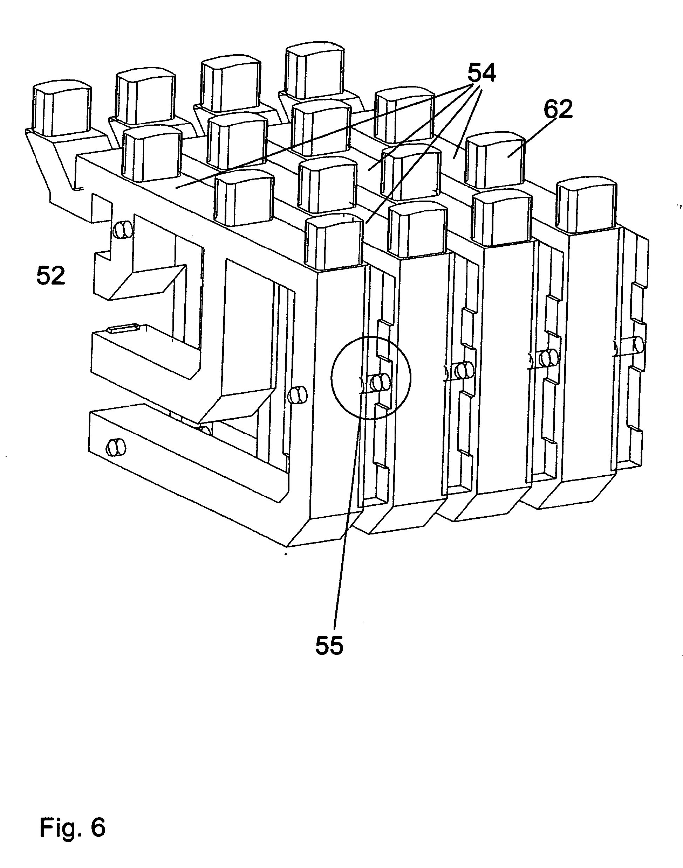

- **Fig. 6**: eine beispielhafte Zapfen-Loch-Verbindung von aufeinandergestapelten Gleichteilen,

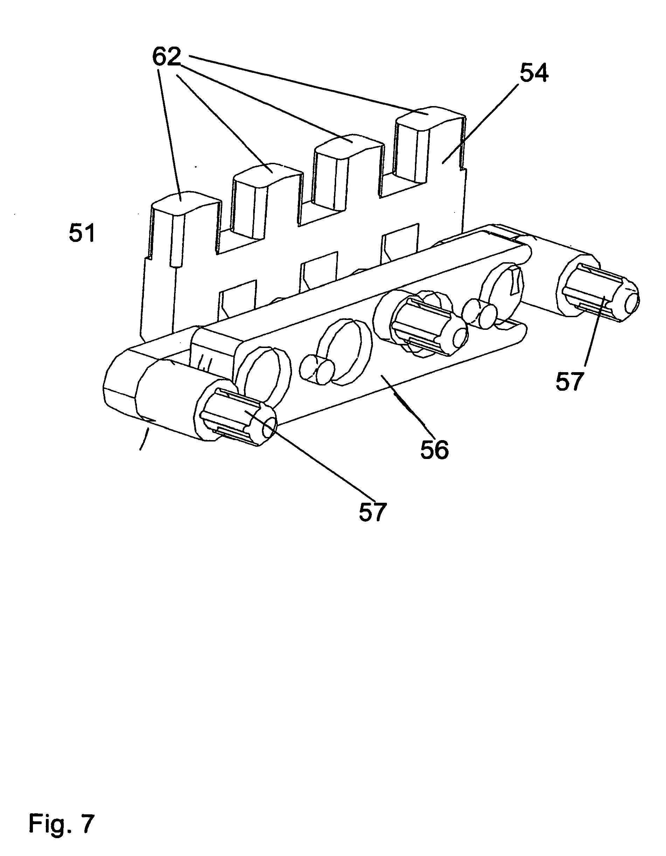

- **Fig. 7**: eine beispielhafte Ausführung eines Anzeigemittels, welches auf der ers- ten Leiterplatte angeordnet ist,

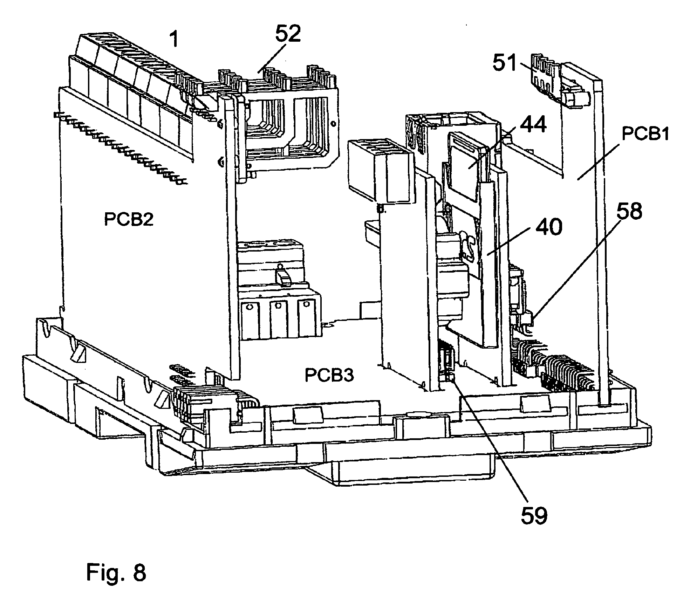

- **Fig. 8**: eine beispielhafte Ausführung der Aufnahme des nachrüstbaren Zubehörs und der Steckplätze zur Aufnahme desselben,

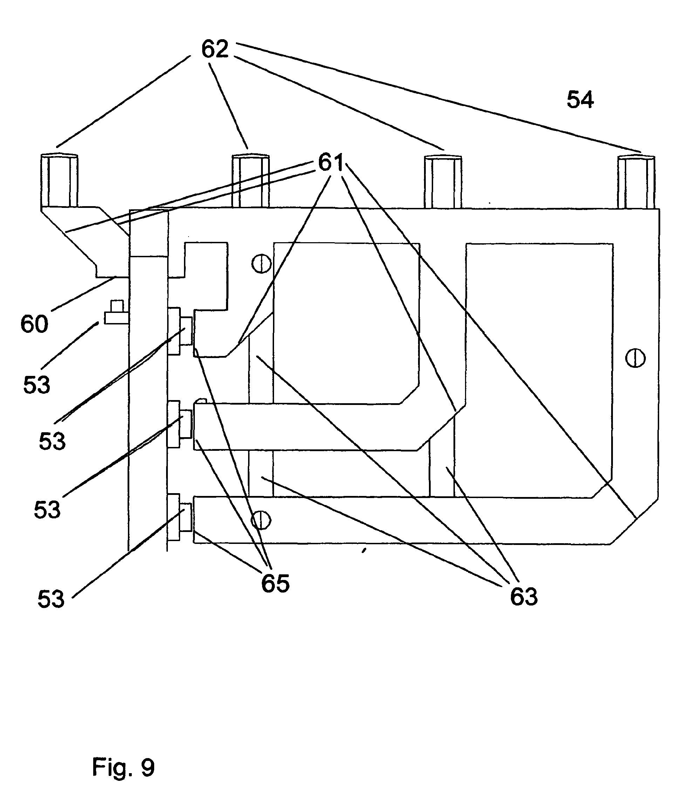

- **Fig. 9**: eine beispielhafte Ausgestaltung eines Gleichteiles des Lichtleiters, und

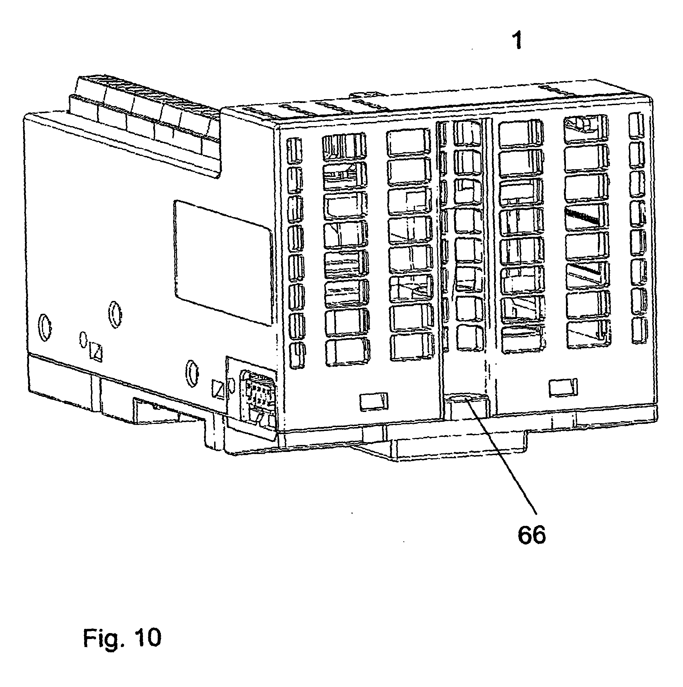

- **Fig. 10**: die Zentralbaugruppe mit einem beispielhaften Durchbruch zur Wandbe- festigung mittels Schrauben.

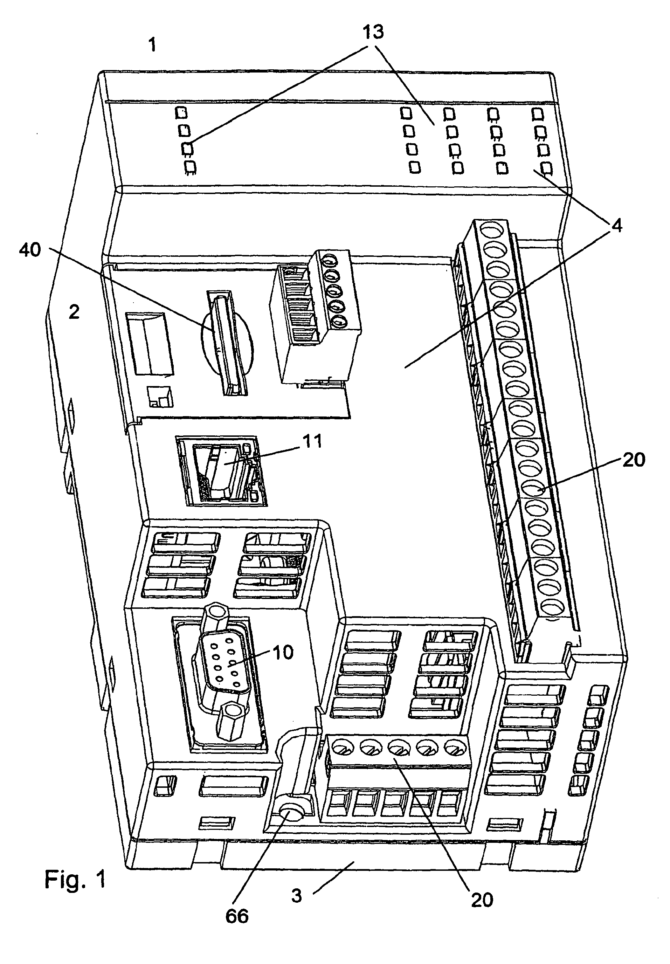

**Fig. 1** zeigt eine beispielhafte Ausführung einer Zentralbaugruppe 1 für ein flexibles erweiterbares Automatisierungsgerät zur Steuerung und/oder Überwachung eines technischen Prozesses mit einem Gehäuse 2 auf dessen Gehäuseunterteil 3 die Elektronikbaugruppe für die Spannungs-Versorgung der Zentralabbaugruppe 1 angeordnet ist sowie einer Gehäusefrontseite 4.

An der Gehäusefrontseite 4 sind eine serielle Schnittstelle 10, eine Ethernet-Schnittstelle 11, eine, vorzugsweise abdeckbare, Vorrichtung 40 als Steckplatz für die Aufnahme von nachrüstbarem Zubehör sowie Anschlusselemente 20 angeordnet.

Die abdeckbare Vorrichtung 40 mit Steckplätzen ist für die Aufnahme von austauschbaren Leiterplatten für weitere Interfaceschaltungen, beispielsweise für eine zusätzliche serielle Schnittstelle, als Sockel für Speicherkarten und/oder zur Aufnahme einer Leiterplatte für eine Echtzeituhr vorgesehen.

Weiterhin weist die Gerätefrontseite 4 Anzeigemittel 13 für die Anzeige der Ein- und Ausgabemodule auf, die als Lichtleiter ausgeführt sind. Die Lichtleiter sind dafür vorgesehen, das Licht an einer festgelegten Stelle zu bündeln und kontaktlos auf die Frontseite 4 der Zentralbaugruppe 1 zu übertragen. Durch das in den verwendeten Lichtleitern gebündelte Licht wird somit in vorteilhafter Weise erreicht, dass das Licht nur an einer Stelle auf der Frontseite 4 der Zentralbaugruppe 1 ausgegeben wird.

In einer besonderen Ausführungsform der Zentralbaugruppe 1 ist diese für eine Wandmontage vorgesehen. Dazu sind die dritte Leiterplatte und das Gehäuseunterteil 3 mit wenigstens einem Durchbruch 66 versehen, der zur Aufnahme von Befestigungsmitteln, vorzugsweise Schrauben, für die Wandmontage vorgesehen ist.

**Fig**. 2 zeigt eine beispielhafte Ausführung der Leiterplatten PCB1, PCB2, PCB3 der Zentralbaugruppe 1 mit darauf angeordneten Elektronikbaugruppen für eine Zentraleinheit, eine Spannungsversorgung 60, eine Schnittstelle für den Anschluss von externen Ein- und Ausgabemodulen und interne Ein- und Ausgabemodule.

Die drei Elektronikbaugruppen der Zentralbaugruppe 1 sind jeweils auf einer separaten Leiterplatte PCB1, PCB2, PCB3 angeordnet. Die dritte Leiterplatte PCB3 mit der Spannungsversorgung 60 der Zentralabbaugruppe 1, die der Gerätefrontseite 4 der Zentralbaugruppe 1 gegenüberliegt, ist erfindungsgemäß auf dem Gehäuseunterteil 3 zwischen der ersten Leiterplatte PCB1 und der zweiten Leiterplatte PCB2 angeordnet.

Die Leiterplatten PCB1, PCB2, PCB3 sind im wesentlichen in einem rechten Winkel zueinander angeordnet, wobei die dritte die Spannungsversorgung 60 sowie weitere Anschlusselemente 20 für den Anschluss der externen Ein- und Ausgabemodule aufnehmende Leiterplatte PCB3 zwischen der ersten die Zentraleinheit, die Vorrichtung für die Aufnahme von nachrüstbarem Zubehör 40, Anschlusselemente 20 und die Ethernet-Schnittstelle 11 aufnehmende Leiterplatte PCB1 und der zweiten die internen Ein- und Ausgabemodule aufnehmenden Leiterplatte PCB2 angeordnet ist.

Die erste Leiterplatte PCB1 weist als komplex aufgebaute mehrlagige Leiterplatte vorzugsweise sechs Lagen auf, wohingegen die zweite, vorzugsweise vier Lagen umfassenden, Leiterplatte PCB2 kostengünstiger herstellbar ist.

Auf der ersten und zweiten Leiterplatte PCB1, PCB2 der Zentralbaugruppe 1 sind jeweils die Anzeigemittel 13 aus einem ersten und einem zweiten Lichtleiter 51, 52 gebildet. Eine detaillierte Darstellung der Anzeigemittel ist beispielhaft in **Fig**. 5 gezeigt.

**Fig**. 3 zeigt die elektrische und mechanische Verbindung 30 der im rechten Winkel aufeinander stehenden Leiterplatten PCB1, PCB2, PCB3 der Zentralbaugruppe 1 miteinander, die Anordnung der Lichtleiter 51, 52 auf der ersten und zweiten Leiterplatte PCB1, PCB2 sowie ein Steckerelement 12 für eine Kommunikationsschnittstelle und einen Stecker 5 für einen Ein-/Ausgabebus.

Zur Verbindung der Leiterplatten PCB1, PCB2, PCB3 untereinander weisen die erste und zweite Leiterplatte PCB1, PCB2 in einer bevorzugten Ausführungsform eine Vielzahl von gebogenen Stiften 31 auf, die durch in der dritten Leiterplatte PCB3 vorgesehene Öffnungen geführt und, beispielsweise mittels eines Wellenlötprozesses, verlötet sind.

Die elektrische Verbindung zwischen den Leiterplatten PCB1, PCB2, PCB3 wird durch die mit dem Bezugszeichen 31 gekennzeichneten Lötstifte realisiert.

Durch die vorab beschriebene elektrische und mechanische Verbindung 30, 31 der in der Zentralbaugruppe 1 angeordneten Leiterplatten PCB1, PCB2, PCB3 entfallen teuere Steckverbindungen und es wird eine bessere mechanische Stabilität erreicht.

Auf der dritten Leiterplatte PCB3 ist weiterhin beispielhaft der Durchbruch 66 zur Aufnahme von Befestigungsmitteln für eine Wandmontage der Zentralbaugruppe 1 gezeigt.

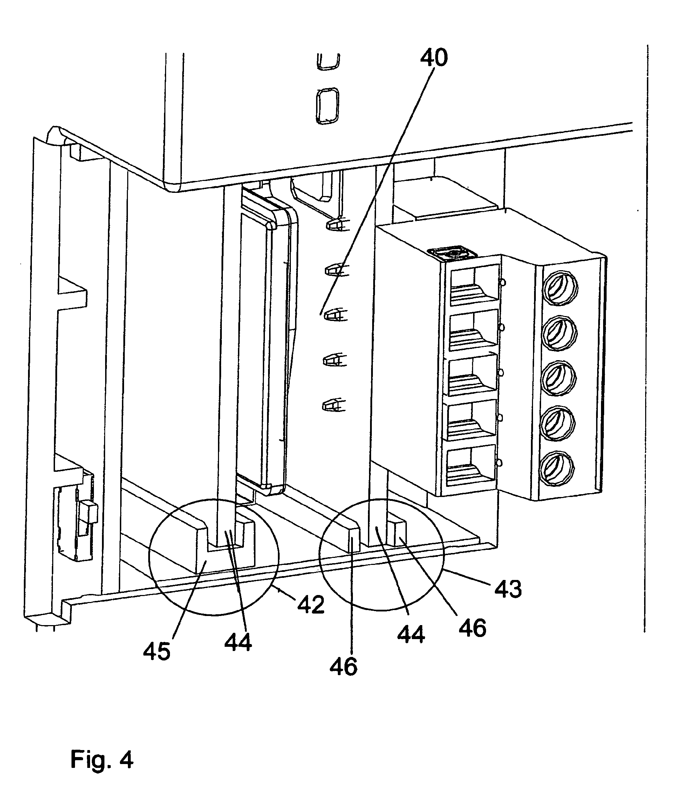

**Fig. 4** zeigt eine Ausführungsform der auf der ersten Leiterplatte PCB1 befindlichen abdeckbaren Vorrichtung 40 als Steckplatz für die Aufnahme von wenigstens einer nachrüstbaren Leiterplatte 44, wobei die Leiterplatte 44 beispielsweise für zusätzliche Schnittstellen, Speicherkarten und/oder zur Aufnahme einer Echtzeituhr vorgesehen ist.

In einer ersten Ausführungsform 42 der Vorrichtung 40 kann die nachzurüstende Leiterplatte 44, beispielsweise in einen Sockel, der aus einer U-förmig ausgebildeten Schiene 45 gebildet wird, eingeschoben werden.

In einer weiteren Ausführungsform 43 wird die Vorrichtung 40 zur Aufnahme der nachzurüstenden Leiterplatte 44 aus zwei langgestreckten schienenförmigen Elementen 46 gebildet, zwischen die die nachzurüstende Leiterplatte 44 eingeschoben wird.

Zur Aufnahme der Leiterplatte 44 sind die langgestreckten quaderförmigen Elemente 46 bzw. die U-förmig ausgebildete Schiene 45 an ihren innenliegenden der einzuschiebenden Leiterplatte 44 zugeneigten Enden abgeschrägt oder abgerundet, um so die Aufnahme der Leiterplatte 44 zu erleichtern.

**Fig**. 5 zeigt eine beispielhafte Ausführung eines Anzeigemittels 13 der Zentralbaugruppe 1, welches auf der zweiten Leiterplatte PCB2 angeordnet ist. Das Anzeigemittel 13 wird durch den zweiten Lichtleiter 52 gebildet, der das von optischen Anzeigeelementen 53, vorzugsweise Leuchtdioden(siehe auch **Fig**. 9) erzeugte Licht bündelt und kontaktlos an die Austrittsöffnungen 62 überträgt. Eine Blende 64 hält den aus vier Gleichteilen 54 aufgebauten zweiten Lichtleiter 52 zusammen und verhindert ein Übersprechen zwischen den einzelnen Strängen des zweiten Lichtleiters 52.

Der zweite Lichtleiter 52 kann aus mehreren hintereinander angeordneten Lichtleitergleichteilen 54 aufgebaut und so ausgestaltet sein, dass zu seiner Herstellung einfache und kostengünstige Spritzgusswerkzeuge verwendbar sind. Die konstruktive Ausgestaltung der Lichtleiter 51, 52 ist der **Fig**. 9 zu entnehmen.

Die Anordnung der Gleichteile 54 wird, beispielsweise durch Aufeinanderstapeln der Gleichteile 54 und eine Verbindung der Gleichteile, vorzugsweise über eine Zapfen-Loch-Verbindung 55, erreicht. Eine beispielhafte Zapfen-Loch-Verbindung 55 von aufeinandergestapelten Gleichteilen 54 zeigt **Fig**. 6.

In **Fig**. 7 ist der erste Lichtleiter 51 gezeigt, der auf der ersten Leiterplatte PCB1 angeordnet ist, wobei auch das von optischen Anzeigeelementen 53 erzeugte Licht vom ersten Lichtleiter 51 gebündelt wird und das vom ersten Lichtleiter 51 gebündelte Licht von den Anzeigeelementen 53 auf Lichtaustrittsflächen 62 an einer zentralen Stelle auf der Frontseite 4 der Zentralbaugruppe 1 übertragen wird.

Der erste Lichtleiter 51 ist gemäß einer bevorzugten Ausführungsform aus einem Gleichteil 54 und einem das Gleichteil 54 aufnehmenden Träger 56 aufgebaut. Der Träger 56 ist dafür vorgesehen gemeinsam mit dem Gleichteil 54 einen Mehrfachlichtleiter zu bilden, der mehrere Lichtpunkte erzeugt. Weiterhin kann der Träger 56 auch Verbindungselemente 57 zur Befestigung des Lichtleiters 51 an der Leiterplatte PCB1 aufweisen. Der Träger 56 verhindert ferner ein Übersprechen zwischen den einzelnen Strängen des Lichtleiters 54.

**Fig**. 8 zeigt eine beispielhafte Ausführung der Aufnahme 40 für das nachrüstbare Zubehör 40 der Zentralbaugruppe 1 mit den Steckplätzen zur Aufnahme desselben auf der ersten bzw. dritten Leiterplatte PCB1, PCB3. Die Steckerelemente 58, 59 zum Anschluss des nachrüstbaren Zubehörs 44, wie beispielsweise einer Kommunikationsschnittstelle oder einer Echtzeituhr auf der ersten Leiterplatte PCB1 bzw. dritten Leiterplatte PCB3 sind mit den Bezugszeichen 58 bzw. 59 gekennzeichnet.

In **Fig**. 9 ist eine beispielhafte Schnittdarstellung eines Gleichteiles 54 des Lichtleiters dargestellt und verdeutlicht die Ausgestaltung des Gleichteiles 54, dass als erster Lichtleiter 51 verwendet wird. Das Gleichteil 54 besteht aus vier einzelnen Lichtleitersträngen. Das Gleichteil ist durch Stege 63 ausgesteift.

Das das von den optischen Anzeigeelementen 53 erzeugte Licht tritt über Eintrittsflächen 65 des Gleichteils 54 ein, wird dann über Totalreflexion an den Flächen 61 reflektiert und tritt an den Austrittsöffnungen bzw. in den Flächen 62 aus.

**Fig**. 10 zeigt die Zentralbaugruppe 1 und den Durchbruch 66 zur Wandbefestigung der Baugruppe 1 mittels Schrauben.

### Bezugszeichenliste

- 1: Zentralbaugruppe
- 2: Gehäuse
- 3: Gehäuseunterteil
- 4: Gehäusefrontseite
- 5: Stecker für Ein-/Ausgabebus
- 10: serielle Schnittstelle
- 11: Ethernet-Schnittstelle
- 12, 58, 59: Steckerelement zum Anschluss von nachrüstbarem Zubehör
- 13: Anzeigemittel
- 20: Anschlusselemente
- 30: Verbindung der Träger untereinander
- 31: Stifte
- 40: Vorrichtung als Steckplatz für die Aufnahme von nachrüstbarem Zubehör
- 41: Öffnung zur Aufnahme zusätzlicher Leiterplatten
- 42: erste Ausführungsform zur Aufnahme einer zusätzlichen Leiterplatte
- 43: zweite Ausführungsform zur Aufnahme einer zusätzlichen Leiterplatte
- 44: zusätzliche Leiterplatte
- 45: Sockel, U-förmige Schiene
- 46: langgestrecktes quaderförmiges Element
- 51: erster Lichtleiter
- 52: zweiter Lichtleiter
- 53: Anzeigeelement
- 54: Gleichteil des Lichtleiters
- 55: Zapfen-Loch-Verbindung
- 56: Träger
- 57: Verbindungselement
- 60: Spannungsversorgung
- 61: Reflexionsfläche
- 62: Austrittsöffnung, Austrittsfläche
- 63: Steg
- 64: Blende
- 65: Eintrittsöffnung
- 66: Durchbruch
- PCB1: erster Träger zur Aufnahme der Elektronikbaugruppe Zentraleinheit
- PCB2: zweiter Träger zur Aufnahme Elektronikbaugruppe der internen Ein- und Ausgabemodule
- PCB3: dritter Träger zur Aufnahme der Elektronikbaugruppe der Spannungsver- sorgung sowie der Schnittstelle für den Anschluss von externen Ein- und Ausgabemodulen

## Patentansprüche

1. Zentralbaugruppe für ein flexibles erweiterbares Automatisierungsgerät umfassend ein Gehäuse (2), welches eine Zentraleinheit, eine Spannungsversorgung (60), eine Schnittstelle für den Anschluss von externen Ein- und Ausgabemodulen und interne Ein- und Ausgabemodule aufnimmt, die Zentralbaugruppe drei Elektronikbaugruppen umfasst, die jeweils auf einem separaten Träger (PCB1), (PCB2), (PCB3) angeordnet sind, wobei der erste Träger (PCB1) die Elektronikbaugruppe der Zentraleinheit aufnimmt, der zweite Träger (PCB2) die Elektronikbaugruppe der internen Ein- und Ausgabemodule aufnimmt, der dritte Träger (PCB3) die Elektronikbaugruppe der Spannungsversorgung (60) sowie die Schnittstelle für den Anschluss von externen Ein- und Ausgabemodulen aufnimmt, **dadurch gekennzeichnet dass** der dritte Träger (PCB3) zwischen dem ersten und dem zweiten Träger (PCB1), (PCB2) gegenüber der Frontseite (4) des Gehäuses (2) angeordnet ist, auf dem Gehäuseunterteil (3) des Gehäuses (2) die Elektronikbaugruppe für die Spannungs-Versorgung der Zentralabbaugruppe (1) angeordnet ist, und auf dem ersten und zweiten Träger (PCB1), (PCB2) als Lichtleiter (51), (52) ausgeführte Anzeigemittel (51), (52) angeordnet sind, die das von optischen Anzeigeelementen (53) erzeugte Licht bündeln und kontaktlos auf die Frontseite (4) der Zentralbaugruppe übertragen.

2. Zentralbaugruppe nach Anspruch 1, **dadurch gekennzeichnet, dass** die Träger (PCB1), (PCB2), (PCB3) zur elektrischen und mechanischen Verbindung (30) untereinander verlötet sind.

3. Zentralbaugruppe nach einen der vorherigen Ansprüche, **dadurch gekennzeichnet, dass** die Träger (PCB1), (PCB2), (PCB3) im wesentlichen rechtwinklig zueinander angeordnet sind, wobei der dritte die Spannungsversorgung (60) sowie die Schnittstelle für den Anschluss der externen Ein- und Ausgabemodule aufnehmenden Träger (PCB3) zwischen dem ersten die Zentraleinheit aufnehmenden Träger (PCB1) und dem zweiten die internen Ein- und Ausgabemodule aufnehmenden Träger (PCB2) angeordnet ist.

4. Zentralbaugruppe nach einen der vorherigen Ansprüche, **dadurch gekennzeichnet, dass** der erste und der zweite Träger (PCB1), (PCB2) steckbare oder verlötbare Klemmen zum Anschluss externer Signale aufweisen.

5. Zentralbaugruppe nach einen der vorherigen Ansprüche, **dadurch gekennzeichnet, dass** der erste Träger (PCB1) gegenüber den zweiten und dritten Träger (PCB2), (PCB3) als komplexe mehrlagige Leiterplatte ausgeführt und die Anzahl der Lagen des ersten Trägers (PCB1) gegenüber der Anzahl der Lagen des zweiten und dritten Trägers (PCB2), (PCB3) erhöht ist.

6. Zentralbaugruppe nach einen der vorherigen Ansprüche, **dadurch gekennzeichnet, dass** der erste Träger (PCB1) eine Ethernet-Schnittstelle (11) aufweist.

7. Zentralbaugruppe nach einen der vorherigen Ansprüche, **dadurch gekennzeichnet, dass** der erste Träger (PCB1) eine serielle Schnittstelle (10) aufweist.

8. Zentralbaugruppe nach einem der vorherigen Ansprüche, **dadurch gekennzeichnet, dass** der erste Träger (PCB1) eine Vorrichtung (40) als Steckplatz für die Aufnahme von nachrüstbaren Leiterplatten, für zusätzliche Schnittstellen, Speicherkarten und/oder zur Aufnahme einer Echtzeituhr aufweist.

## Claims

1. A central assembly group for a flexible extendable automation apparatus comprising a housing (2) which accomodates a central processing unit, a voltage supply (60), an interface for connecting external input and output modules and internal input and output modules, the central assembly group comprises three electronic units which are arranged in each case on a separate carrier (PCB1), (PCB2) (PCB3), the first carrier (PCB1) housing the electronic unit of the central unit, the second carrier (PCB2) housing the electronic unit of the internal input and output modules, the third carrier (PCB3) housing the electronic unit of the voltage supply (60) as well as the interface for connecting external input and output modules, **characterized in that** the third carrier (PCB3) is arranged between the first and the second carrier (PCB1), (PCB2) opposite the front side (4) of the housing (2), the electronic unit for the voltage supply of the central unit (1) is arranged on the lower part (3) of the housing (2), and indication means (51), (52) formed as optical conductors (51), (52), which concentrate the light generated by the optical indication elements (53), are arranged on the first and the second carrier (PCB1), (PCB2), and they transmit the light without contact to the front side (4) of the central assembly group.

2. The central assembly group according to claim 1, **characterized in that** the carriers (PCB1), (PCB2) (PCB3) are welded to one another for the electrical and mechanical connection (30).

3. The central assembly group according to any of the preceding claims, **characterized in that** the carriers (PCB1), (PCB2) (PCB3) are arranged essentially at a right angle to one another, the third carrier (PCB3) housing the voltage supply (60) as well as the interface for connecting the external input and output modules being arranged between the first carrier (PCB1) housing the central unit and the second carrier (PCB2) housing the internal input and output modules.

4. The central assembly group according to any of the preceding claims, **characterized in that** the first and the second carriers (PCB1), (PCB2) have plug-in or weldable terminals for connecting external signals.

5. The central assembly group according to any of the preceding claims, **characterized in that** the first carrier (PCB1) is formed with respect to the second and to the third carrier (PCB2), (PCB3) as a complex multilayer printed circuit board in compensation with the second and third carrier (PCB2), (PCB3) and the number of layers of the first carrier (PCB1) is greater than the number of layers of the second and third carriers (PCB2), (PCB3).

6. The central assembly group according to any of the preceding claims, **characterized in that** the first carrier (PCB1) has an Ethernet interface (11).

7. The central unit according to any of the preceding claims, **characterized in that** the first carrier (PCB1) has a serial interface (10).

8. The central assembly group according to any of the preceding claims, **characterized in that** the first carrier (PCB1) has a device (40) as an insertion slot for housing printed circuit cards which can be retrofitted, for additional interfaces, memory cards and/or for housing a real-time clock.

## Revendications

1. Bloc central pour un dispositif d'automatisation flexible extensible comprenant un boîtier (2), qui loge une unité centrale, une source de tension (60), une interface pour la connexion des modules d'entrée et de sortie externes et des modules, d'entrée et de sortie internes, le bloc central comprenant trois unités électroniques, qui sont disposées dans chaque cas, sur un support (PCB1), (PCB2) (PCB3) séparé, le premier support (PCB1) logeant l'unité électronique de l'unité centrale, le deuxième support (PCB2) l'unité électronique des modules d'entrée et de sortie internes, le troisième support (PCB3) l'unité électronique de la source de tension (60) ainsi que l'interface pour la connexion des modules d'entrée et de sortie externes, **caractérisé en ce que** le troisième support (PCB3) est disposé entre le premier et le deuxième support (PCB1), (PCB2) en regard du côté avant (4) du boîtier (2), sur la partie inférieure de boîtier (3) du boîtier (2) est disposée l'unité électronique pour le bloc central (1), et sur le premier et le deuxième support (PCB1), (PCB2) sont disposés des moyens d'indication (51) (52) réalisés comme conducteurs optiques (51), (52) qui concentrent la lumière générée par des éléments d'indication optiques (53) et la transmettent sans contact au côté avant (4) du bloc central.

2. Bloc central selon la revendication 1, **caractérisé en ce que** les supports (PCB1), (PCB2) (PCB3) sont soudés ensemble pour la connexion (30) électrique et mécanique.

3. Bloc central selon l'une des revendications précédentes, **caractérisé en ce que** les supports (PCB1), (PCB2) (PCB3) sont disposés essentiellement à angle droit les uns par rapport aux autres, le troisième support (PCB3) qui loge la source de tension (60) ainsi que l'interface pour la connexion des modules d'entrée et de sortie externes étant logé entre le premier support (PCB1) qui loge l'unité centrale et le deuxième support (PCB2) qui loge les modules d'entrée et de sortie internes.

4. Bloc central selon l'une des revendications précédentes, **caractérisé en ce que** le premier et le deuxième support (PCB1), (PCB2) ont des bornes enfichables ou soudables pour la connexion des signaux externes.

5. Bloc central selon l'une des revendications précédentes, **caractérisé en ce que** le premier support (PCB1) est réalisé par rapport au deuxième et au troisième support (PCB2), (PCB3) comme une carte de circuit imprimé complexe à plusieurs couches et le nombre de couches du premier support (PCB1) est supérieur au nombre de couches du deuxième et du troisième support (PCB2), (PCB3).

6. Bloc central selon l'une des revendications précédentes, **caractérisé en ce que** le premier support (PCB1) a une interface (11) Ethernet.

7. Bloc central selon l'une des revendications précédentes, **caractérisé en ce que** le premier support (PCB1) a une interface (10) en série.

8. Bloc central selon l'une des revendications précédentes, **caractérisé en ce que** le premier support (PCB1) comprend un dispositif (40) comme rainure d'insertion pour loger des cartes de circuit imprimé qui peuvent être montées postérieurement, pour des interfaces supplémentaires, des cartes mémoire et/ou pour loger une horloge temps réel.
